# EUROPEAN PATENT APPLICATION

(11) **EP 3 006 593 A1**
(43) Date of publication of application: **13.04.2016**
(21) Application number: 14804339.1
(22) Date of filing: 08.05.2014
(51) Int. Cl.: C23C 14/02, C23C 14/56, C23C 16/02, C23C 16/54

(54) **DEGASSING DEVICE**

(30) Priority: 31.05.2013 JP 2013115014
(71) Applicant: Kabushiki Kaisha Kobe Seiko Sho (Kobe Steel, Ltd.), Kobe-shi, Hyogo 651-8585 (JP)
(72) Inventor: SEGAWA, Toshiki, Hyogo 676-8670 (JP); OHBA, Naoki, Hyogo 676-8670 (JP)
(74) Representative: TBK
(86) International application number: PCT/JP2014/062362
(87) International publication number: WO 2014/192513

(57) **Abstract**

Provided is a degassing device which allows efficient maintenance. This degassing device is provided with upper and lower rollers (18A, 18B) which advance a film-forming material (10) in an advancement direction while vertically conveying the same, a plate heater (12) arranged adjacently to the film-forming material (10) moving back and forth between the rollers, and a chamber (14) having an outer wall. The outer wall includes a front wall (20) and a rear wall (22) each having an upper roller support unit (20a, 22a) and a lower roller support unit (20b, 22b). In at least one of the front wall (20) and the rear wall (22), a between-roller opening (40, 42) is formed in the region between the upper roller support unit and the lower roller support unit, and said between-roller openings (40, 42) have a shape cutting across the moving film-forming material (10) and the plate heater (12) in the advancement direction.

## Description

### TECHNICAL FIELD

The present invention relates to a device for performing degassing treatment by heating a belt-shaped film substrate on which a coating is to be deposited.

### BACKGROUND ART

Before a coating is deposited to a thin film substrate on which the coating is to be deposited that is formed by a long film or sheet by sputtering or plasma chemical vapor deposition (CVD), degassing treatment as pretreatment thereof may be performed. This degassing treatment is to heat the film substrate and remove, as a gas, oligomers and water that remain therein from the film substrate, and heating of the film substrate is performed, for example, by radiation from plate heaters to the film substrate or a direct contact of a heating roller with the film substrate.

Conventionally, as degassing device using the plate heaters, a degassing device disclosed in Patent Document 1 has been known. This device includes a plurality of rollers arranged each at an upper side and a lower side, a plurality of plate heaters, and a chamber that houses these. The upper rollers and the lower rollers are each arranged to be shifted away from each other in a movement direction in such a manner as to convey the film substrate in a vertical direction while moving the same in a horizontal direction. The plate heaters are arranged in a vertical posture between vertical portions of the conveyed film substrate one another that are adjacent to each other in the movement direction, and heat, by radiation, portions of the film substrate that are positioned at both sides of the plate heaters. The chamber includes side walls that rotatably support both ends of each free roller.

In the degassing device based on the plurality of free rollers and plate heaters as described above, a space packing ratio of components is high so that making the device compact is possible, whereas there is a problem in that maintenance operations, such as cleaning of each free roller and plate heater and operations of so-called feeding of the film substrate are not easy. In other words, in the chamber, the plurality of rollers, the plurality of portions of the conveyed film substrate that are adjacent to each other in the movement direction, and the plate heaters arranged between these portions one another crowd together in the movement direction so that performing maintenance of these and the like is not easy.

As a common method for enabling the above maintenance, providing a large opening for operations in a top wall from among walls composing the chamber that does not contribute to supporting each free roller can be considered, but with this opening, effective and efficient maintenance operations cannot be expected. Specifically, when an assembly of combination of the free rollers and plate heaters is seen through the opening from the upper side, the size of spaces of the free rollers, the plate heaters, and the film substrate in the movement direction of the film substrate (direction in which the free rollers and the plate heaters are arranged) are small, whereas the size of an overall depth (i.e. vertical size) of the assembly is large, so that, even if operators insert their arms through the opening to perform operations, a range in which the operations are performable is considerably limited.

### CITATION LIST

### PATENT DOCUMENT

Patent Document 1: JP 2010-053382 A

### SUMMARY OF THE INVENTION

An object of the present invention is to provide a degassing device including a plurality of rollers for conveying a film substrate on which the coating is to be deposited in a vertical direction while moving the same in a horizontal direction, and a plurality of plate heaters, the device being capable of efficiently performing maintenance thereof.

The present invention provides a device that performs degassing treatment on a belt-shaped film substrate on which a coating is to be deposited by conveying the film substrate in a longitudinal direction thereof while heating the same, the film substrate extending in a particular direction, the device including: a plurality of guide rollers that guide the film substrate in such a manner as to convey the film substrate in a vertical direction while moving the same in a particular movement direction orthogonal thereto, the guide rollers including a plurality of upper rollers arranged at intervals in the movement direction and a plurality of lower rollers arranged at intervals in the movement direction at a position lower than the upper rollers; at least one plate heater arranged in a vertical posture between portions of the film substrate as conveyed in the vertical direction one another that are adjacent to each other and radiating heat to heat the portions; and a chamber that houses the guide rollers and the plate heater. The chamber includes an outer wall that encloses the guide rollers and the plate heater, in which an outer wall formed with an opening through which the inside and outside of the outer wall communicate with each other is included. When a direction parallel to a rotation center shaft of each guide roller is defined as a front-rear direction, the outer wall includes a front wall and a rear wall that are respectively positioned at both sides of the guide rollers and the plate heater in the front-rear direction, the front wall and rear wall respectively including upper roller support portions that rotatably support end portions of each upper roller in an axial direction, and lower roller support portions that rotatably support end portions of each lower roller in the axial direction at a position lower than the upper roller support portions. The opening includes an inter-roller opening formed in an area between the upper roller support portions and the lower roller support portions in at least one of the front wall and rear wall, and the inter-roller opening has such a shape as to traverse in the movement direction the film substrate as conveyed in the vertical direction and each plate heater.

### BRIEF DESCRIPTION OF DRAWINGS

[Fig. 1] Fig. 1 is a front sectional view of a film deposition apparatus according to a first embodiment of the present invention.
[Fig. 2] Fig. 2 is a sectional view taken along line II-II in Fig. 1.
[Fig. 3] Fig. 3 is a front sectional view of a film deposition apparatus according to a second embodiment of the present invention.
[Fig. 4] Fig. 4 is a plan view of the film deposition apparatus according to the second embodiment of the present invention.

### DESCRIPTION OF EMBODIMENTS

Hereinafter, preferred embodiments of the present invention will be described with reference to the drawings.

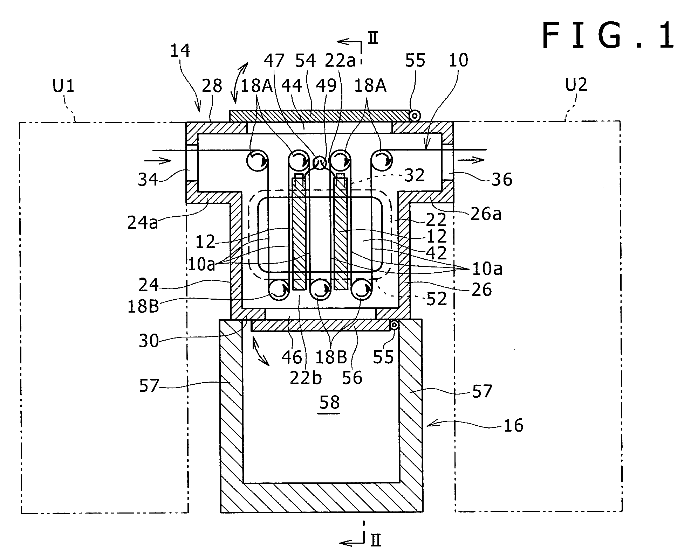

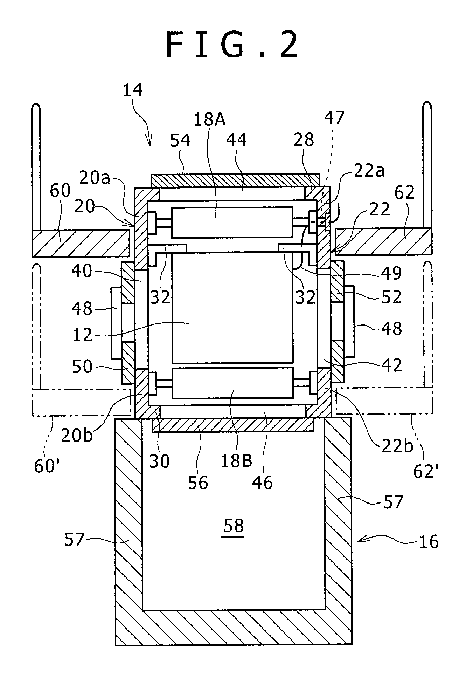

In Figs. 1 and 2, a degassing device according to a first embodiment of the present invention is illustrated. The degassing device according to this embodiment is configured to be one of units composing, for example, a film deposition system. Specifically, this degassing device is arranged, as illustrated in Fig. 1, between an upstream unit U1 that executes an upstream process thereof and a downstream unit U2 that executes a downstream process thereof, performs degassing treatment by heating a belt-shaped film substrate 10 on which the coating is to be deposited that is discharged from the upstream unit U1 while conveying the same in a longitudinal direction thereof, and feeds the film substrate 10 as treated to the downstream unit U2. The film substrate 10 is long and flexible similarly to a plastic film, for example, and the degassing treatment thereof is performed by heating the film substrate 10 and separating, as a gas, oligomers and water that are contained, and remain in the film substrate 10 from the film substrate. If this degassing device is incorporated, for example, in the film deposition system for depositing a film on a surface of the film substrate 10, the upstream unit U1 corresponds to, for example, a feeding unit including a feeding roller, and the downstream unit U2 corresponds to, for example, a film deposition unit including a film deposition roller.

The degassing device according to this embodiment includes a plurality of guide rollers, a plurality of plate heaters 12, a chamber 14 that houses these guide rollers and plate heaters 12, and a support frame 16 that supports this chamber 14 from below.

The plurality of guide rollers are arranged, as illustrated in Fig. 1, to guide the film substrate 10 in such a manner as to convey the film substrate 10 in a vertical direction while moving the same in a horizontal direction that is a particular movement direction orthogonal thereto, each of which is supported by the chamber 14 in such a manner as to be rotatable about an a shaft extending in a front-rear direction (overall depth direction in Fig. 1) of the device.

Specifically, the plurality of guide rollers includes a plurality of upper rollers 18A and a plurality of lower rollers 18B. Each upper roller 18A is arranged at a particular height position (height position adjacent to an upper end of the chamber 14 in this embodiment) at intervals in the movement direction (horizontal direction), each of which is substantially identical to a diameter of the lower rollers 18B. Each lower roller 18B is arranged at a height position lower than the upper rollers 18A (height position adjacent to a lower end of the chamber 14 in this embodiment) at intervals in such a manner as to be positioned between the upper rollers 18A one another that are adjacent to each other in the movement direction. In the present invention, the number of the guide rollers are not limited, but in this embodiment, four pieces of the upper rollers 18A and three pieces of the lower rollers 18B are arranged above and below, respectively, and accordingly, in relation to a group of these rollers 18A, 18B, the film substrate 10 is fed from the height position of the upper rollers 18A and led out from the same height position.

In relation to these upper rollers 18A and lower rollers 18B, the film substrate 10 is wound about these rollers 18A, 18B in a zigzag manner in such a manner as to alternately pass around an upper side of each upper roller 18A and a lower side of each lower roller 18B. Accordingly, a conveying force is applied to the film substrate 10 along a longitudinal direction thereof, thereby enabling the film substrate 10 to be conveyed in the vertical direction while moving in the horizontal direction.

Each of the plate heaters 12 is plate-shaped and arranged at such a position as to efficiently heat, by heat generation thereof, the film substrate 10. Specifically, the film substrate 10 wound about the rollers 18A, 18B in such a manner as to be conveyed in the vertical direction as described above has a plurality of vertical portions 10a (six pieces in total in an example illustrated in Fig. 1) arranged in the movement direction thereof, and the plate heaters 12 are arranged in a vertical posture between these vertical portions 10a one another that are adjacent to each other. In the present invention, the number of the plate heaters is not limited, and, in this embodiment, the plate heaters 12 are arranged each between the vertical portions 10a located at corresponding second and third positions, counting from an upstream side of the movement direction, and between the vertical portions 10a located at corresponding fourth and fifth positions.

The chamber 14 includes an outer wall that encloses the guide rollers 18A, 18B and the plate heaters 12, in which an outer wall formed with a plurality of openings through which the inside and outside of the outer wall communicate with each other is included. The outer wall includes a front wall 20, a rear wall 22, a left wall 24, a right wall 26, a top wall 28, and a bottom wall 30.

When a direction parallel to a rotation center shaft of each of the rollers 18A, 18B is defined as the front-rear direction of the device as described above, the front wall 20 and the rear wall 22 are side walls respectively positioned at both sides of the rollers 18A, 18B and the plate heaters 12 in the front-rear direction, and rotatably support end portions of the rollers 18A, 18B in an axial direction, respectively, while being in a vertical posture. In other words, the front wall 20 and the rear wall 22 include upper roller support portions 20a, 22a, respectively, that rotatably support the end portions of the upper rollers 18A in the axial direction, and lower roller support portions 20b, 22b, respectively, that rotatably support the end portions of the lower rollers 18B in the axial direction. In this embodiment, the upper roller support portions 20a, 22a are composed of portions adjacent to upper ends of the front wall 20 and rear wall 22, respectively, and the lower roller support portions 20b, 22b are composed of portions adjacent to lower ends of the front wall 20 and rear wall 22, respectively.

In this first embodiment, each of the plate heaters 12 is also supported by the front wall 20 and the rear wall 22. Specifically, an upper end portion of each plate heater 12 is connected through a heater fixing tool 32 to appropriate portions (portions immediately below the upper rollers 18A in cases of Figs. 1 and 2) of the corresponding front wall 20 and rear wall 22.

When the movement direction of the film substrate 10 is defined as the horizontal direction of the device, the left wall 24 and the right wall 26 are side walls respectively arranged in a vertical posture at both sides of the rollers 18A, 18B and the plate heaters 12 in the horizontal direction, and both end portions thereof in the front-rear direction are connected to end portions of each of the front wall 20 and rear wall 22 in the horizontal direction.

Upper portions of these left and right walls 24, 26 project leftward and rightward, respectively, to form a feeding portion 24a and a lead-out portion 26a, respectively. A chamber inlet port 34 and a chamber outlet port 36 are formed at an end portion of the feeding portion 24a and an end portion of the lead-out portion 26a, respectively. The feeding portion 24a is connected to the upstream unit U1 such that the film substrate 10 discharged from the upstream unit U1 enters the chamber 14 through the chamber inlet port 34, and the lead-out portion 26a is connected to the downstream unit U2 such that the film substrate 10 as subjected to the degassing treatment is fed to the downstream unit U2 through the chamber outlet port 36. Further, to the chamber 14, an exhaust pump, a control panel, and the like that are unillustrated are connected, those of which operate together to realize favorable degassing treatment.

The top wall 28 and the bottom wall 30 are respectively arranged in a horizontal posture at both sides of the rollers 18A, 18B and each of the plate heaters 12 in the vertical direction. These top wall 28 and bottom wall 30 are each rectangular, and respectively connected to upper end portions and lower end portions of each of the side walls 20, 22, 24, and 26. Thereby, a sealed space having a substantially rectangular prism shape can be formed in the chamber 14.

The outer wall of the chamber 14 as described above are formed with, as the openings, front and rear inter-roller openings 40, 42, an upper opening 44, and a lower opening 46.

The inter-roller openings 40, 42 are formed in corresponding areas between the upper roller support portions 20a, 22a and the lower roller support portions 20b, 22b in the front wall 20 and rear wall 22, respectively, and each have such a shape as to traverse, in the movement direction (horizontal direction), each vertical portion 10a of the film substrate 10 as conveyed in the vertical direction as described above and each of the plate heaters 12, such as a horizontally oriented rectangular shape.

In this embodiment, a front cover 50 and a rear cover 52 that are covers for respectively opening and closing the inter-roller openings 40, 42 are rotatably attached through a hinge to the front wall 20 and the rear wall 22, respectively. Each of the covers 50, 52 is provided with an observation window 48, and inspection can be performed through these observation windows 48 while the covers 50, 52 are closed. The heater fixing tools 32 are connected to corresponding portions of the corresponding front wall 20 and rear wall 22 immediately above the inter-roller openings 40, 42, respectively. Moreover, at a height substantially equal to that of these portions, a wiring port 47 that is a hole through which a wiring 49 for heater for feeding power to each of the plate heaters 12 is also provided.

The inter-roller openings 40, 42 each having the shape as described above traverse, in corresponding areas between the upper roller support portions 20a, 22a and the lower roller support portions 20b, 22b, respectively, the plurality of vertical portions 10a (of the film substrate 10) and main portions of the plate heaters 12 at a front side or rear side thereof that crowd together between the upper rollers 18A and lower rollers 18B in the movement direction, thereby enabling the front wall 20 and the rear wall 22 to support each of the guide rollers 18A, 18B, while, through the inter-roller openings 40, 42, enabling operations of maintaining each of the rollers 18A, 18B and plate heaters 12 in a wide range and operations of winding the film substrate 10 about each of the rollers 18A, 18B to be effectively and efficiently performed.

Further, the inter-roller openings 40, 42 allow the size of the plate heaters 12 in the vertical direction to be enlarged and the size of the chamber 14 in the movement direction (horizontal direction) to be accordingly reduced. For example, in a device in which the upper and lower rollers 18A, 18B and the plate heaters 12 are accessible only from an upper side, if the size of spaces between the upper rollers 18A and the lower rollers 18B and the size of the plate heaters 12 in the vertical direction are enlarged, arms or tools for maintenance can no longer reach lower portions of the plate heaters 12 and the lower rollers 18B, which remarkably limits these sizes, whereas, in the device including the inter-roller openings as described above, even if the distance between the upper rollers 18A and the lower rollers 18B and the size of the plate heaters 12 in the vertical direction are enlarged, accordingly enlarging the size of the inter-roller openings in the vertical direction allows favorable maintenance operations to be ensured.

Providing such inter-roller openings at only one side of either the front wall 20 or the rear wall 22 is effective, but forming the same in both the side walls 20, 22 as illustrated in Figs. 1 and 2 is more preferable. This not only further facilitates maintenance operations, but reduces a difference in degree of reduction in rigidity of the front wall 20 and the rear wall 22 due to formation of the inter-roller openings to equalize degrees of deformation of the front wall 20 and the rear wall 22 due to a load applied by the upper and lower rollers 18A, 18B, thereby allowing the levelness of the rollers 18A, 18B to be kept high.

The upper opening 44 and the lower opening 46 are formed in the top wall 28 and the bottom wall 30, respectively. In the examples illustrated in Figs. 1 and 2, the upper opening 44 has such a size as to open each upper roller 18A upward, and the lower opening 46 has such a size as to open each lower roller 18B downward. Thus, through these openings 44, 46, facilitating cleaning of each of the rollers 18A, 18B and operations of winding the film substrate 10 is possible. Moreover, an upper cover 54 and a lower cover 56 that are covers for respectively opening and closing each of the openings 44, 46 are rotatably attached through a hinge 55 in the horizontal direction to the top wall 28 and the bottom wall 30, respectively.

The support frame 16 has a frame shape in which a plurality of posts 57 extending in the vertical direction, and supports the chamber 14 from below mainly by the posts 57, thereby forming a space 58 for operations below the lower opening 46 and inside each of the posts 57. This space 58 preferably has such a space as to allow operators to enter the same in a reasonable posture. This support frame 16 performs a role of facilitating maintenance of the lower rollers 18B and operations of setting the film substrate 10 by utilizing the lower opening 46.

As illustrated in Fig. 2, the degassing device according to this first embodiment further includes platforms 60, 62 for performing operations through the upper opening. These platforms 60, 62 are arranged at corresponding both sides of the chamber 14 in the front-rear direction. A height position of these platforms 60, 62 may be a position away from the inter-roller openings 40, 42 in the vertical direction so as not to disturb maintenance operations through the inter-roller openings 40, 42, may be a position upper than each of the inter-roller openings 40, 42 as illustrated by a solid line in Fig. 2, and may be a position lower than each of the inter-roller openings 40, 42 as illustrated by two-dot chain lines 60', 62' in the same drawing.

The platforms 60, 62 disposed at such positions can facilitate operations through the upper opening 44, while not deteriorating a function of the inter-roller openings 40, 42 and allowing the upstream unit U1 and the downstream unit U2 to be arranged in the movement direction (horizontal direction) as illustrated in Fig. 1.

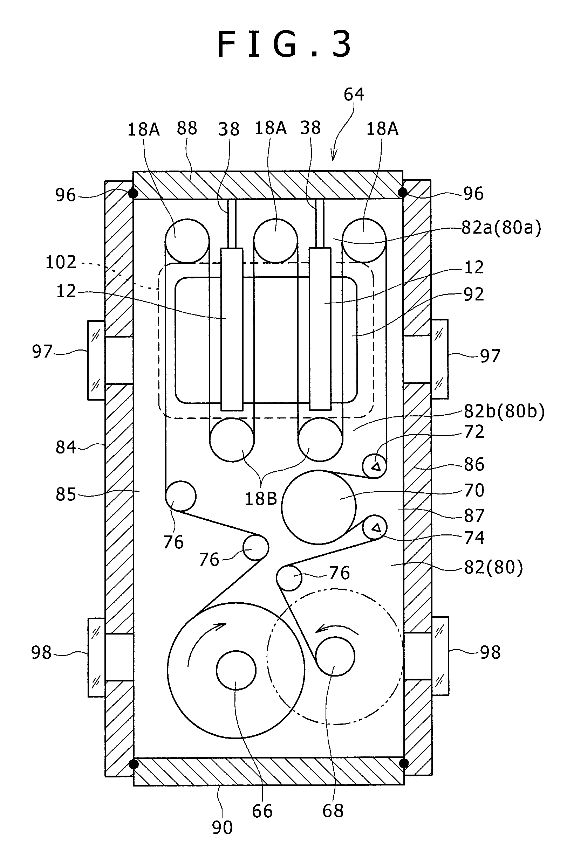

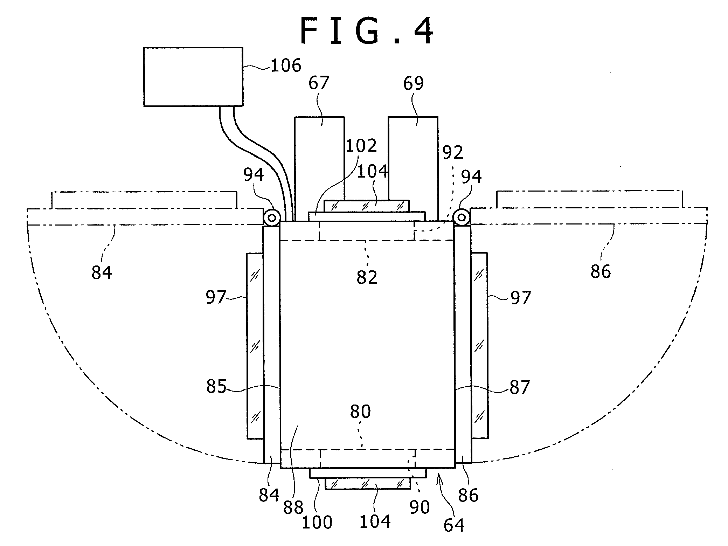

In Figs. 3 and 4, a degassing device according to a second embodiment of the present invention is illustrated.

The degassing device according to the first embodiment of the present invention is incorporated, for example, in a film deposition system as a process unit that is a unit thereof, and performs the degassing treatment on the film substrate 10 fed from the upstream unit U1 before feeding the same to the downstream unit U2, whereas the degassing device according to the second embodiment of the present invention is configured as a device dedicated for degassing treatment.

Specifically, the degassing device according to this second embodiment of the present invention, which includes, similarly to the first embodiment, the plurality of guide rollers including the plurality of upper rollers 18A and the plurality of lower rollers 18B, the plurality of plate heaters 12, a chamber 64 that houses these guide rollers and plate heaters 12, additionally includes a feeding roller 66, a take-up roller 68, a cooling roller 70, a pair of tension detection rollers 72, 74, and a plurality of free rollers 76 that guide the film substrate 10 into a predetermined shape.

An arrangement of the upper rollers 18A, the lower rollers 18B, and the plate heaters 12 is similar to that in the device according to the first embodiment, and a feature in which the upper rollers 18A and the lower rollers 18B are arranged in such a manner as to convey the film substrate 10 in the vertical direction while moving the same in the horizontal direction, and a feature in which the plate heaters 12 are arranged between the vertical portions 10a of the conveyed film substrate 10 one another to heat the film substrate 10 are the same as those of the device according to the first embodiment.

In the device according to this second embodiment, the support frame 16 according to the first embodiment is not included, but, alternatively, the chamber 64 has a vertically oriented substantially rectangular prism shape that extends over the entirety of the device in the vertical direction. Moreover, the feeding roller 66 and the take-up roller 68 are housed in a lower part of this chamber 64, and the cooling roller 70 is arranged at a position between the take-up roller 68 and the lower rollers 18B.

The feeding roller 66 holds a so-called feed roll on which the film substrate 10 to be subjected to degassing treatment is wound, and rotates about a shaft in a direction (front-rear direction) parallel to a rotation shaft of each of the rollers 18A, 18B, thereby feeding out the film substrate 10 from the feed roll toward the rollers 18A, 18B. The take-up roller 68 rotates similarly about a shaft in the front-rear direction, thereby taking up the film substrate 10 that has passed the rollers 18A, 18B.

The cooling roller 70 contacts with the film substrate 10 at a position between the rollers 18A, 18B and the take-up roller 68, thereby cooling the film substrate 10 that has been heated by the plate heaters 12. This cooling roller 70 is connected to an unillustrated motor, thereby functioning also as drive roller that provides a conveying force to the film substrate 10. Each of the tension detection rollers 72, 74 respectively converts tensile forces of the film substrate 10 upstream and downstream of the cooling roller 70 that also serves as drive roller as described above into an electric signal, and inputs the same to an unillustrated control panel. If a tensile force detected by these tension detection rollers 72, 74 is abnormal, a control for automatically stopping the device is performed.

The chamber 64 includes an outer wall similarly to the chamber 14 according to the first embodiment, and this outer wall includes a front wall 80, a rear wall 82, a left wall 84, a right wall 86, a top wall 88, and a bottom wall 89. The front wall 80 and the rear wall 82 are respectively arranged in a vertical posture at both sides of the rollers 18A, 18B and the plate heaters 12 in the front-rear direction, the left wall 84 and the right wall 86 are respectively arranged in a vertical posture at both sides of the rollers 18A, 18B and the plate heaters 12 in the horizontal direction (movement direction of the film substrate 10), and the top wall 88 and the bottom wall 89 are respectively arranged in a horizontal posture at both sides of the rollers 18A, 18B and the plate heaters 12 in the vertical direction.

The front wall 80 and the rear wall 82 includes, similarly to the front wall 20 and the rear wall 22 according to the first embodiment, upper roller support portions 80a, 82a, respectively, that rotatably support the end portions of the upper roller 18A in the axial direction, and lower roller support portions 80b, 82b, respectively, that rotatably support the end portions of the lower roller 18B in the axial direction, and, in the front wall 80 and the rear wall 82, inter-roller openings 90, 92 that traverse, in corresponding areas between the upper roller support portions 80a, 82a and the lower roller support portions 80b, 82b, respectively, each vertical portion 10a of the film substrate 10 as conveyed in the vertical direction while moving in the horizontal direction and the plate heaters 12 in the movement direction of the film substrate 10 are formed, respectively. Covers 100, 102 that respectively covers and uncovers the inter-roller openings 90, 92 are rotatably attached through a hinge to the front wall 80 and the rear wall 82, respectively, and each of the covers 100, 102 is provided with an observation window 104 through which inspection in the chamber 64 can be performed while these covers 100, 102 are closed.

However, in this second embodiment, differently from the first embodiment, the lower roller support portions 80b, 82b are composed of middle parts of the front wall 80 and the rear wall 82 in the vertical direction thereof, respectively, and portions in an area lower than the lower roller support portions 80b, 82b rotatably support both ends of the feeding roller 66, the take-up roller 68, the cooling roller 70, and the tension detection rollers 72, 74 in the axial direction.

The feeding roller 66 and the take-up roller 68 are arranged side by side in the lower part of the chamber 64 in the horizontal direction and supported by the front wall 80 and the rear wall 82 in such a manner as to be detachable relative to the walls 80, 82. To the rear wall 82, roller drive motors 67, 69 for rotationally driving the feeding roller 66 and the take-up roller 68, respectively, are connected, and the roller drive motors 67, 69 have corresponding output shafts that can be detachably connected to the feeding roller 66 and the take-up roller 68, respectively. Moreover, to the chamber 64, a necessary incidental tool, such as a dry pump 106 and a control panel that are separately placed, is connected.

In this embodiment, each of the plate heaters 12 is supported by the top wall 88 while being suspended from the top wall 88. Specifically, a top end of each plate heater 12 and the top wall 88 are connected to each other through a heater fixing tool 38.

End portions of the front wall 80 and the rear wall 82 in the vertical direction and end portions of the top wall 88 and the bottom wall 89 in the front-rear direction are integrally connected to each other, while rear end portions of the corresponding left and right walls 84, 86 are each connected in a manner rotatable about a shaft to the same in the vertical direction through a hinge 94. In other words, the left and right walls 84, 86 are configured to be doors for covering and uncovering corresponding left and right openings 85, 87 that are surrounded by the front wall 80, the rear wall 82, the top wall 88, and the bottom wall 89.

Further, this device includes seal rings 96 for sealing the chamber 64. These seal rings 96 each have a rectangular shape, and are fixed to one surface of a left and right both end surface of each of the walls 80, 82, 88, 89 that corresponds to a periphery of the openings and an inner surface of an outer periphery portion of the left and right walls 84, 86 that faces the corresponding surface, and adhered to the other surface when the left and right walls 84, 86 that are doors are closed, thereby sealing the chamber 64.

Through the left and right openings 85, 87 that are covered and uncovered by the left and right walls 84, 86, the above configuration allows: 1) operations of taking in and out the left and right feeding roller 66 and take-up roller 68; 2) operations of feeding the film substrate 10 between the rollers 66, 68 and the rollers 18A, 18B (set operations); and 3) operations of maintaining each roller adjacent to the left and right openings 85, 87 to be facilitated.

Further, the left and right walls 84, 86 are provided with a plurality of observation windows 97, 98. The observation windows 97 are provided at a height position corresponding to a middle part of the vertical portions 10a and plate heaters 12, and the observation windows 98 are provided at a height position corresponding to the feeding roller 66 and the take-up roller 68. These observation windows 97, 98 allows inspection of the vertical portions 10a, the plate heaters 12, each of the rollers 66, 68, and the like to be performed while the left and right covers 84, 86 that are doors are closed.

In this second embodiment, the left and right walls 84, 86 are so configured as to be doors that pivot to cover and uncover the left and right openings 85, 87, respectively, but the left and right walls 84, 86 may be integrally connected to the other walls 80, 82, 88, 89 that compose the outer wall and the left and right openings 85, 87 may be formed in the left and right walls 84, 86. Also in this case, the left and right openings 85, 87 preferably have such a size as to allow the feeding roller 66 and the take-up roller 68 to be taken in and out through the left and right openings 85, 87, respectively.

With the degassing device according to this second embodiment, for example, the film substrate 10 as subjected to the degassing treatment can be obtained by the following procedure.
1) The left and right walls 84, 86 are opened, and through the left and right openings, the feeding roller 66 that holds a feed roll (one on which the film substrate 10 as not treated is wound) and the empty take-up roller 68 are each set in the chamber 64.
2) The film substrate 10 is taken out from the feeding roller 66, wound about between the upper and lower guide rollers 18A, 18B in a zigzag manner, and further wound around the tension detection roller 72, the cooling roller 70, and the tension detection roller 74 in this order, and an end portion of the film substrate 10 is fixed to the take-up roller 68.
3) The left and right walls 84, 86 are closed, and each motor, the control panel, and the other tools are operated to perform the degassing treatment. Specifically, the feeding roller 66 and the take-up roller 68 are rotationally driven, thereby feeding out the film substrate 10 from the feeding roller 66, successively performing the degassing treatment on the film substrate 10 by a combination of the guide rollers 18A, 18B, and the plate heaters 12, and taking up the film substrate 10 as treated by the take-up roller 68.
4) After completion of the degassing treatment, the left and right walls 84, 86 are opened, and the empty feeding roller 66 and the take-up roller 68 that has taken up the film substrate 10 are taken out. The film substrate 10, as subjected to the degassing treatment, that has been taken up on the take-up roller 68 is used in a next step (film deposition process, for example).

Further, the procedure of 1) to 4) is repeatedly performed so that the film substrate as subjected to the degassing treatment can be successively provided. Moreover, as described above, the inter-roller openings 90, 92 and the left and right openings 85, 87 are utilized to perform efficient maintenance operations.

In the device according to this second embodiment, at least one of the covers 100, 102 that respectively covers and uncovers the inter-roller openings 90, 92 may be one that slides in the front-rear direction, thereby covering and uncovering the inter-roller openings. For example, the front cover 100 is rotatably attached through a hinge to the front wall 80 in such a manner as to cover and uncover the inter-roller opening 90, while the rear cover 102 may be supported by the rear wall 82 in such a manner as to uncover the inter-roller opening 92 by sliding in such a manner as to be drawn rearward. In this case, each of the plate heaters 12 can be supported by the cover 102 in such a manner as to slide integrally with the cover 102 in the front-rear direction. Also in this device, maintenance operations can be facilitated. For example, it is also possible that maintenance operations and operations of so-called feeding of the film substrate are performed while the rear cover 102 is drawn rearward before the cover 102 is made to slide together with the plate heaters 12 to cover the rear inter-roller opening 92, and then a working operation is started.

Moreover, the present invention does not exclude one in which, in addition to the plate heaters 12, the other heaters, such as a heating roller, are provided. In other words, the present invention can be applied to one that includes at least a plate heater as a heating element.

As described above, according to the present invention, the degassing device including the plurality of rollers for conveying the film substrate in the vertical direction while moving the same in the horizontal direction, and the plurality of plate heaters, the device being capable of efficiently performing maintenance thereof is provided. This device is a device that performs degassing treatment on a belt-shaped film substrate on which a coating is to be deposited by conveying the film substrate in a longitudinal direction thereof while heating the same, the film substrate extending in a particular direction, the device including: a plurality of guide rollers that guide the film substrate in such a manner as to convey the film substrate in a vertical direction while moving the same in a particular movement direction orthogonal thereto, the guide rollers including a plurality of upper rollers arranged at intervals in the movement direction and a plurality of lower rollers arranged at intervals in the movement direction at a position lower than the upper rollers; at least one plate heater arranged in a vertical posture between portions of the film substrate as conveyed in the vertical direction one another that are adjacent to each other in the movement direction and radiating heat to heat the portions; and a chamber that houses the guide rollers and the plate heater. The chamber includes an outer wall that encloses the guide rollers and the plate heater, in which an outer wall formed with an opening through which the inside and outside of the outer wall communicate with each other is included. When a direction parallel to a rotation center shaft of each of the guide rollers is defined as a front-rear direction, the outer wall includes a front wall and a rear wall that are respectively positioned at both sides of the guide rollers and the plate heater in the front-rear direction, the front wall and rear wall respectively including upper roller support portions that rotatably support end portions of each of the upper rollers in an axial direction, and lower roller support portions that rotatably support end portions of each of the lower rollers in the axial direction at a position lower than the upper roller support portions. The opening includes an inter-roller opening formed in an area between the upper roller support portions and the lower roller support portions in at least one of the front wall and rear wall, and the inter-roller opening has such a shape as to traverse in the movement direction the film substrate as conveyed in the vertical direction and each of the plate heaters.

The inter-roller opening of this device is formed between the upper roller support portions and the lower roller support portions in at least one of the front wall and rear wall, and traverse the plurality of portions of the film substrate and the plate heater at a front side or rear side thereof that crowd together between the upper rollers and lower rollers in the movement direction, thereby enabling the front wall and the rear wall to support each guide roller, while, through the inter-roller opening, enabling operations of maintaining each guide roller and the plate heater in a wide range and operations of feeding the film substrate (operations of winding the film substrate about each of the guide rollers) to be effectively and efficiently performed.

The inter-roller opening is preferably formed in both the front wall and the rear wall. This not only further facilitates maintenance operations, but also reduces a difference in rigidity of the front wall and the rear wall to equalize degrees of deformation of the front wall and the rear wall due to a load applied by each of the guide rollers, thereby allowing the levelness of each guide roller to be kept high.

Further preferably, the outer wall is further formed with the other openings, as the opening, in addition to the inter-roller opening. For example, in a case in which the outer wall includes a top wall and a bottom wall that are respectively positioned at an upper side and a lower side of the guide rollers and the plate heater, as the opening, an upper opening and a lower opening may be formed in the top wall and the bottom wall, respectively. In this case, the degassing device preferably further includes a support member that supports the chamber from below and forms a space for operations below the lower opening. This combination of the support member and the lower opening allows maintenance of each guide roller and the plate heater to be performed not only from an upper side but also from a lower side of the chamber.

In this case, the degassing device preferably includes a platform for performing operations through the upper opening, and the platform is suitably arranged at at least one side of the chamber in the front-rear direction at a position away from the inter-roller opening in the vertical direction. The platform provided at such a position never becomes an obstacle to maintenance operations through the inter-roller opening, but allows another process unit to be arranged at at least one side of the chamber in the movement direction while operations through the upper opening can be facilitated.

The degassing device according to the present invention may be integrally incorporated, as a unit of a film deposition apparatus, therein, and may be configured as a dedicated device independent of a film deposition apparatus. For example, the degassing device according to the present invention may further include, in addition to each of the guide rollers, a feeding roller that feeds out the film substrate to each of the guide rollers while rotating about a shaft extending in the front-rear direction, and a take-up roller that takes up the film substrate from each of the guide rollers while rotating about a shaft extending in the front-rear direction, in which the feeding roller and the take-up roller together with the guide rollers may be housed in the chamber.

In this case, preferably, the feeding roller and the take-up roller are provided in such a manner as to be arranged side by side in a horizontal direction orthogonal to the rotation center shaft of each of the guide rollers at a position away from each of the guide rollers in the vertical direction, the outer wall of the chamber is formed with, as the opening, left and right openings positioned at left and right sides of the outer wall, respectively, and the left and right openings have such a size as to allow the feeding roller and the take-up roller to be taken in and out through the left and right openings, respectively. On the basis of this configuration, the compact device dedicated for degassing treatment that can complete degassing treatment in the single chamber in which the feeding roller as feed roll can be easily taken in and the take-up roller as product roll can be easily taken out can be provided.

## Claims

1. A device that performs degassing treatment on a belt-shaped film substrate on which a coating is to be deposited by conveying the film substrate in a longitudinal direction thereof while heating the same, the film substrate extending in a particular direction, the device comprising:
a plurality of guide rollers that guide the film substrate in such a manner as to convey the film substrate in a vertical direction while moving the same in a particular movement direction orthogonal thereto, the guide rollers including a plurality of upper rollers arranged at intervals in the movement direction and a plurality of lower rollers arranged at intervals in the movement direction at a position lower than the upper rollers;
at least one plate heater arranged in a vertical posture between portions of the film substrate as conveyed in the vertical direction one another that are adjacent to each other in the movement direction and radiating heat to heat the portions; and
a chamber that houses the guide rollers and the plate heater, wherein the chamber includes an outer wall that encloses the guide rollers and the plate heater, in which an outer wall formed with an opening through which the inside and outside of the outer wall communicate with each other is included,
when a direction parallel to a rotation center shaft of each of the guide rollers is defined as a front-rear direction, the outer wall includes a front wall and a rear wall that are respectively positioned at both sides of the guide rollers and the plate heater in the front-rear direction, the front wall and rear wall respectively including upper roller support portions that rotatably support end portions of each of the upper rollers in an axial direction, and lower roller support portions that rotatably support end portions of each of the lower rollers in the axial direction at a position lower than the upper roller support portions, and
the opening includes an inter-roller opening formed in an area between the upper roller support portions and the lower roller support portions in at least one of the front wall and rear wall, and the inter-roller opening has such a shape as to traverse in the movement direction the film substrate as conveyed in the vertical direction and each of the plate heaters.

2. The degassing device according to claim 1,
wherein the inter-roller opening is formed in both the front wall and the rear wall.

3. The degassing device according to claim 1,
wherein the outer wall includes a top wall and a bottom wall that are respectively positioned at both sides of the guide rollers and the plate heater in the vertical direction, as the opening, an upper opening and a lower opening are formed in the top wall and the bottom wall, respectively, and the degassing device further comprises a support member that supports the chamber from below and forms a space for operations below the lower opening.

4. The degassing device according to claim 3, further comprising a platform for performing operations through the upper opening,
wherein the platform is arranged at at least one side of the chamber in the front-rear direction at a position away from the inter-roller opening in the vertical direction.

5. The degassing device according to any one of claims 1-4, further comprising: a feeding roller that feeds out the film substrate to each of the guide rollers while rotating about a shaft extending in the front-rear direction; and a take-up roller that takes up the film substrate from each of the guide rollers while rotating about a shaft extending in the front-rear direction,
wherein the feeding roller and the take-up roller together with the guide rollers are housed in the chamber.

6. The degassing device according to claim 5,
wherein the feeding roller and the take-up roller are provided in such a manner as to be arranged side by side in a horizontal direction orthogonal to the rotation center shaft of each of the guide rollers at a position away from each of the guide rollers in the vertical direction, the outer wall of the chamber is formed with, as the opening, left and right openings positioned at left and right sides of the outer wall, respectively, and the left and right openings have such a size as to allow the feeding roller and the take-up roller to be taken in and out through the left and right openings, respectively.
